# EUROPEAN PATENT SPECIFICATION

(11) **EP 1 236 285 B1**
(45) Date of publication and mention of the grant of the patent: **22.03.2006**
(21) Application number: 00983188.4
(22) Date of filing: 29.11.2000
(51) Int. Cl.: H04B 1/28, H03H 11/22

(54) **RECEIVER CIRCUIT**
EMPFÄNGERSCHALTUNG
CIRCUIT DE RECEPTION

(30) Priority: 09.12.1999 GB 9929182
(43) Date of publication of application: 04.09.2002
(73) Proprietor: TELEFONAKTIEBOLAGET LM ERICSSON (publ), 164 83 Stockholm (SE)
(72) Inventor: VAN ZEIJL, Paulus, Thomas, Maria, NL-7559 AD Hengelo (NL)
(74) Representative: O'Connell, David Christopher
(86) International application number: PCT/EP2000/011985
(87) International publication number: WO 2001/043295

(56) References cited:
- US-A- 4 857 777
- US-A- 5 084 686
- US-A- 5 644 260

## Description

### Field of the invention

The invention relates to an image reject circuit and to a method of rejecting images.

### Background of the invention

Transceivers utilise frequency mixers for converting high frequency signals to low frequency signals or vice versa. Such conversion is required, for example, to convert a signal from a desired frequency to an intermediate frequency (IF), an intermediate frequency (IF) being the difference between an incoming carrier frequency and a local-oscillator (LO) frequency.

When converting frequencies in this manner an undesired image frequency is generated, and consequently, various methods have been developed to effectively eliminate the image signal.

Until recently, off-chip filters have been used to provide image rejection. However, the physical size of the components involved means that such circuits are not suited for implementation on an integrated circuit.

An alternative approach to filtering the image signal is to cancel the image signal. Image cancellation or rejection mixers consist, for example, of two mixers, driven by two local-oscillator signals which have a 90° phase difference, and an IF phase shifter such that the two IF signals are again phase shifted (usually 45° in one branch and 135° in the second branch) and a combiner or summing circuit. The result is that when the signals are summed, the desired signal components are added together while the undesired image signal components are cancelled, resulting in a receiver having image rejection.

Image rejection circuits such as these rely on the accurate values of components. However, nominally identical components vary due to temperature variations, process spread and/or ageing and, as a consequence, calibration is therefore required during manufacture. For example, this can involve taking measurements during the manufacturing stage, and adjusting programmable resistors and/or capacitors accordingly.

As well as adding to the manufacturing process, once programmed the circuits are fixed, and cannot adapt to changes which may occur during use or ageing.

Another known method of improving image rejection is to use an inaccurate 90° phase shifter in the local oscillator path, which is corrected by an RC-polyphase correction network. However, to obtain an image rejection of about 50-60dB using this type of solution, the components within the respective devices must be matched to within 0.1%. Since mismatch usually scales inyersely with silicon area, a large silicon area is therefore required to obtain an acceptable image rejection. A large silicon area impies large parasitic capacitances to the substrate, which in turn compromises high frequency performance. Also, the integrated circuit layout is very critical, as any parasitic capacitance or resistance degrades image rejection.

In addition to the disadvantages mentioned above, improving image rejection in the IF path will have limited effect unless corresponding steps are taken to improve image rejection in the LO path.

US 5,870,670 to Ripley relates to a known image reject circuit having phase shifting networks in both the LO stage and IF stage.

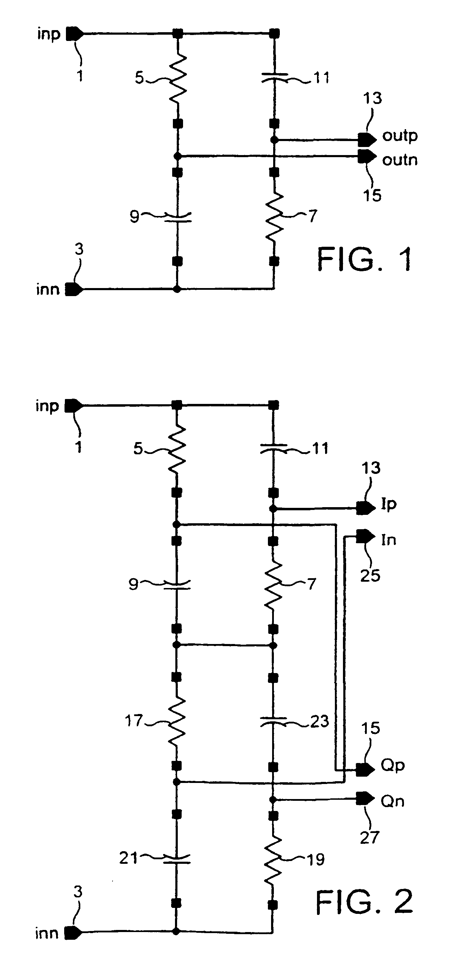

Known circuits for realising phase-shifters are shown in Figures 1 and 2 respectively, in which Figure 1 uses an all-pass phase shifter and Figure 2 uses a high-pass/low-pass phase shifter. Further known solutions use inductors to realise the phase shifter in the LO path. However, inductors are large and thus not suited for implementation in an integrated circuit, (since two inductors of approximately 300 *µ*m x 300*µ*m are required).

Figure 1 shows a conventional all-pass phase shifter in which the input signal is connected to terminals 1, 3 which are connected across a bridge formed by resistors 5, 7 and capacitors 9, 11. Input signal 1 is connected to the junction of resistor 5 with capacitor 11, while the input signal 3 is connected to the junction of resistor 7 with capacitor 9. The balanced output signal 13 and signal 15 are taken respectively from the junction of resistor 7 with capacitor 11, and the junction of resistor 5 with capacitor 9. The output signals 13, 15 are phase shifted relative to the input signals 1, 3 by an amount determined by the values of the resistors and capacitors.

A first part of Figure 1 with R=600Ω and C=1pF, (f=100 MHZ), gives a balanced I signal with, phase shifted by 45° from the input signal, while a second part with R=3840Q and C=1pF, (f=100 MHZ), gives the Q signal, phase shifted by 135° from the input signal. The phase difference between the I and Q signals is then 90°.

Ideally, the all-pass phase shifter described above should have a flat amplitude response over all frequencies. However, the impedance levels of the I and Q branches are significantly different, which makes realisation of the flat amplitude difficult in practice. The phase shift equals 2*arctan(ωRC), and is usually made 45° in the I branch and 135° in the Q branch. The phase shift is only optimal at one frequency. Thus, this all-pass phase shifter does not give sufficient performance for obtaining an image rejection of 40dB or more, and a wide bandwidth, in the presence of process spread (for example from wafer to wafer), and mismatch (for example between components on the same wafer) .

As mentioned above, Figure 2 shows another known phase shifter for the LO path, and relates to a high-pass/low-pass phase shifter. Basically, this phase shifter comprises two all-pass phase shifters of Figure 1 connected together as shown, using a second bridge consisting of resistors 17, 19 and capacitors 21, 23 connected to the first bridge. The input signal 1 is connected to the junction resistor 5 with capacitor 11, while the input signal 3 is connected to the junction of resistor 19 with capacitor 21. Unlike Figure 1, the high-pass/low-pass phase shifter has a correct phase shift of 90° over all frequencies. This phase shifter has the advantage that the impedance in the I and Q branches are the same. The amplitude, however, will vary with frequency. Limiters are commonly used to lower the amplitude errors, but exhibit amplitude-to-phase conversions, thus generating phase errors from the amplitude errors. For this reason, the use of high-pass/low-pass phase shifters does not allow the mixing circuits to fulfill the requirement of image rejection.

The aim of the present invention is to provide an image rejection circuit which overcomes the disadvantages mentioned above.

### Summary of the invention

According to a first aspect of the present invention, there is provided an image reject circuit comprising:
a local oscillator for producing a local oscillator signal;
a tunable phase shifting network for receiving the local oscillator signal and producing an output in-phase (I) signal and an output quadrature (Q) signal;
a first amplitude detector for determining the amplitude of the output I signal;
a second amplitude detector for determining the amplitude of the output Q signal; and,
means for determining the difference between the amplitudes of the output I and Q signals, to produce a tuning signal for tuning the phase shifting network to bring the difference between the amplitudes of the output I and Q signals towards a desired level.

According to another aspect of the present invention, there is provided a method of rejecting an image signal, the method comprising the steps of a local oscillator for producing a local oscillator signal, and a tunable phase shifting network for receiving the local oscillator signal and producing an output in-phase (I) signal and an output quadrature (Q) signal, the method comprising the steps of;
determining the amplitude of the output I signal;
determining the amplitude of the output Q signal;
determining the difference between the amplitudes of the output I and Q signals, to produce a tuning signal; and,
using the tuning signal to tune the phase shifting network to bring the difference between the amplitudes of the output I and Q signals towards a desired level.

### Brief Description of the drawings

For a better understanding of the present invention, and to show more clearly how it may be carried into effect, reference will now be made, by way of example, to the accompanying drawings, in which:-
Figure 1 shows a conventional all-pass phase shifter;
Figure 2 shows a conventional high-pass/low-pass phase shifter;
Figure 3 shows an image rejection, circuit according to a first aspect of the present invention;
Figure 4 shows a tunable high-pass/low-pass phase shifter for use in Figure 3, according to a second aspect of the present invention;
Figure 5 shows a known amplitude detector for use in Figure 3;
Figure 6 shows another known amplitude detector for use in Figure 3;
Figures 7a-7d show the response of an RC phase shifter according to the prior art; and,
Figures 8a-8d show the response of an RC phase shifter according to the preferred embodiment of the present invention.

### Detailed description of a preferred embodiment of the present invention

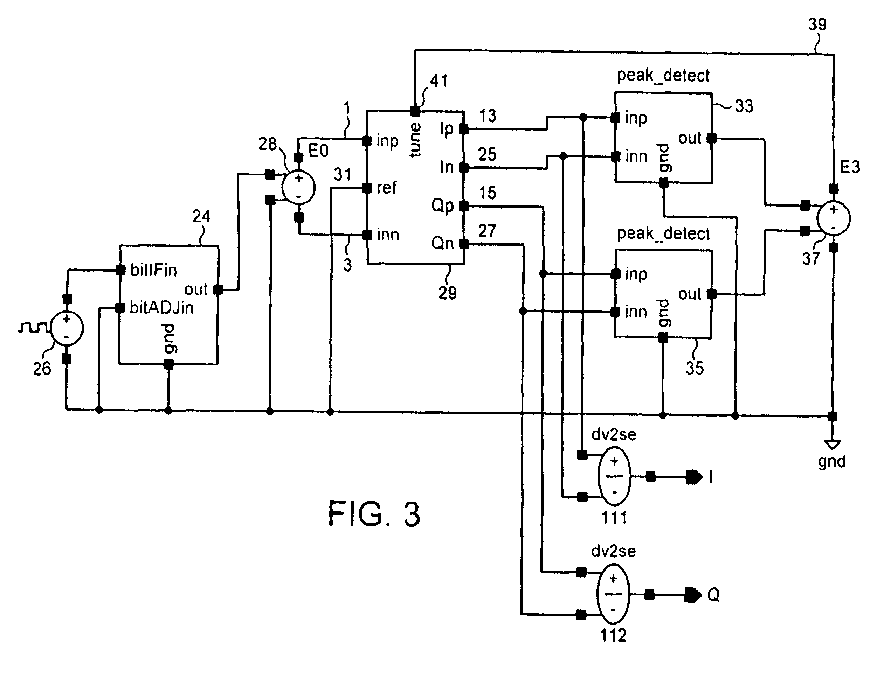

Figure 3 shows a schematic diagram of an image rejection circuit according to the present invention. A voltage controlled oscillator 26 generates a LO signal, the frequency of which is dictated by circuit 24. The output of circuit 24 is connected to a voltage follower 28, which provides a balanced input signal 1, 3. Alternatively, in practice, items 24, 26 and 28 may be replaced by an oscillator/PLL circuit.

An RC tunable phase shifter 29 has first and second inputs for receiving the input signal 1, 3. It also receives a reference signal 31 which is connected, for example, to ground. The phase shifter 29 outputs complementary I and Q signals 13, 25 and 15, 27 respectively.

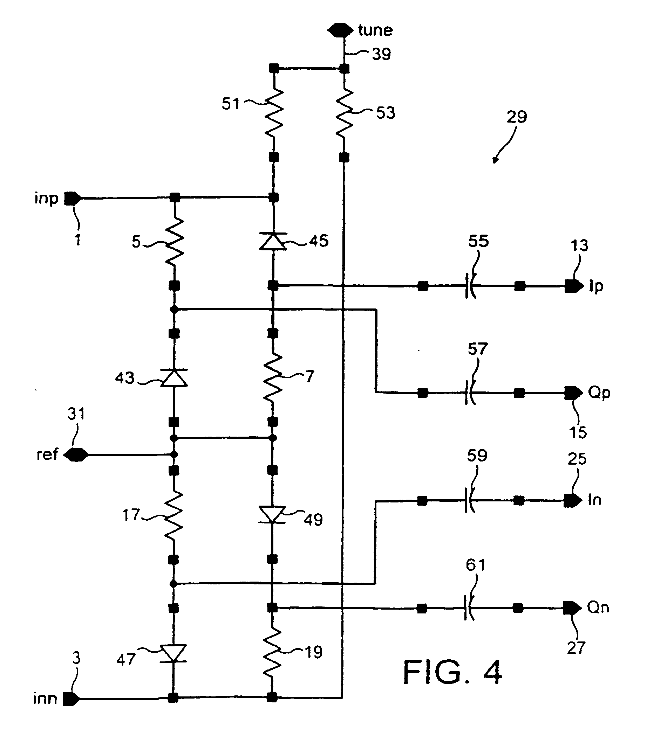

The I output signals 13, 25 are connected to a first peak or amplitude detector 33 which determines the amplitude of the I signal. The Q output signals 15, 27 are connected to a second peak or amplitude detector 35 which determines the amplitude of the Q signal. The outputs of the first and second peak detectors 33 and 35 are compared in a comparator 37, which produces a difference signal, or tuning signal 39 based on the difference between the amplitudes of the I and Q signals. The tuning signal 39 is fed back to the "tune" input 41 of the RC phase shifter 29, and is used to tune the RC phase shifter as described below with reference to Figure 4.

Thus, in use, as the frequency of the input signal changes, say from 2.0 to 3.4 GHz, the amplitudes of the I and Q signals will change accordingly. The change in amplitudes is detected by each of the peak detectors 33, 35, thereby causing the tuning signal 39 to change. The tuning signal 39 is fed back to the RC phase shifter 29, which tunes the phase shifter such that the amplitudes of the I and Q signals become substantially equal once more, thereby maintaining optimum image rejection.

Figure 4 shows the tunable RC phase shifter of Figure 3 in greater detail, in accordance with a second aspect of the invention. The tunable RC phase shifter 29 is similar to the phase shifter of Figure 2 in that it basically comprises two all-pass phase shifters connected together. However, the capacitors 9, 11, 21 and 23 have respectively been replaced by junction diodes 43, 45, 47 and 49. The difference signal or tuning signal 39 is connected to opposite ends of the phase shifter via resistors 51 and 53. Preferably, capacitor 55, 57, 59, 61 are provided in series with each of the output terminals 13, 15, 25 and 27 respectively, for minimising of the interaction with the remaining circuitry.

The junction diodes 43, 45, 47, 49 function in a similar way to varactor diodes, such that varying the DC voltage across the diodes causes the capacitance of the diodes to be changed, thus enabling the phase shifter to be tuned. The tuning signal 39 is the difference between the amplitudes of the I and Q signals, which has been fed back from the comparator 37 as described in Figure 3. Thus, the tunable RC phase shifter 29 can continually and automatically compensate for differences in amplitude between the I and Q signals which may have been caused by, for example, variation of components, or variation introduced by ageing or temperature fluctuations.

The embodiment described above tunes the phase shifter by varying the capacitance (i.e. by varying the voltage across the junction diodes 43, 45, 47 and 49). Alternatively, the phase shifter may be tuned by varying the resistance of the resistors 5, 7, 17 and 19, for example by operating a MOSFET in its triode region, such that it functions as a voltage dependent resistor. In such an embodiment, the gate of the MOSFET is connected to the tuning signal, and the drain and source are connected to the respective resistor connections.

Thus, the RC time constant may be changed by either varying the capacitance alone, varying the resistance alone, or varying a combination of the capacitance value and the resistance value.

Alternatively, either the resistive elements or the capacitive elements described above may be replaced by inductive elements, such that the time constant can be varied by changing the LC or RL time constants respectively.

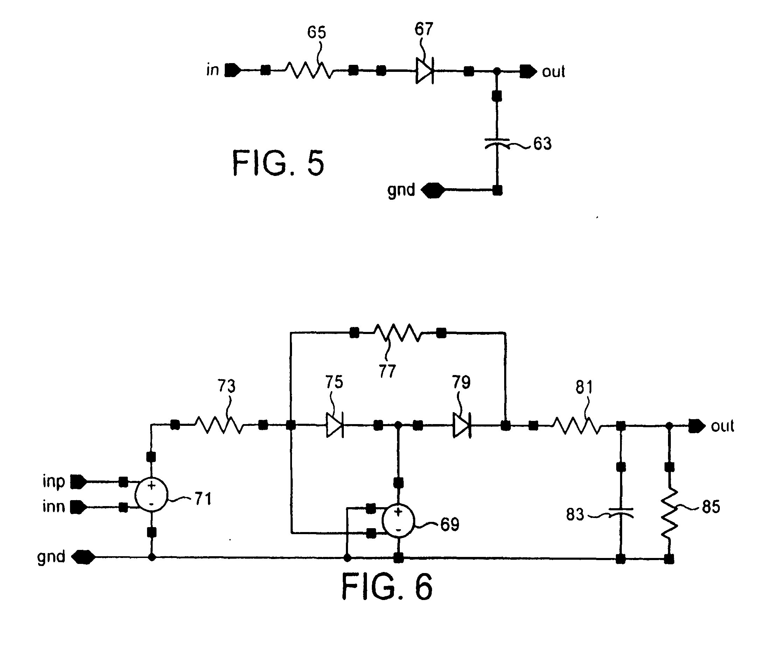

Figure 5 shows a known peak detecting circuit for measuring the amplitude of the I and Q signals. The input signal is connected to the first terminal of a capacitor 63 via a series connected resistor 65 and forward polarity diode 67. The capacitor 63 stores the peak amplitude of the input signal, which is made available at the output terminal. This type of circuit is particularly suited to high frequency applications.

Figure 6 shows an alternative circuit for determining the peak amplitude of the I and Q signals, and is also known in the art. The circuit of Figure 6 has the advantage of being more sensitive, and is capable of detecting smaller signals than that of Figure 5, (i.e. below the diode voltage drop). It is noted that the voltage controlled voltage source 69 may be replaced by an operational amplifier.

Although two alternative circuits for determining the peak amplitude have been shown in Figures 5 and 6, other circuits for measuring the peak amplitude may also be used without departing from the scope of the invention. For example, amplitude detectors using quadratic function circuits may be used.

Furthermore, any small residual errors still present in the amplitudes of the output signals may be corrected by adding a limiter stage to the RC phase shifter. Since only a small amplitude error is to be corrected, the limiter can have a limited gain or power consumption, thereby avoiding the disadvantages mentioned above in relation to limiter circuits.

Alternatively, any error residual errors may be removed by adding an RC poly-phase filter section, having a small Si-area, for example after the tunable phase shifter and before the following stages (i.e. mixer) .

Although the embodiment described above uses the amplitude difference to tune the phase-shifter in the LO path, the tuning signal 39 may also be used to tune a phase shifter provided in the IF path.

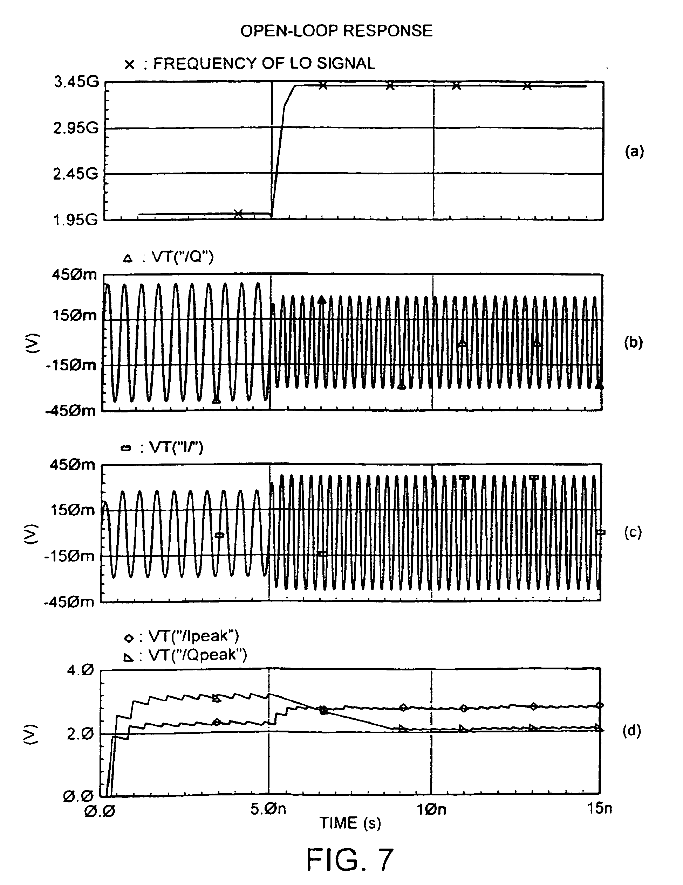

Figure 7 shows the response of an open-loop simulation, ie. without the feedback circuitry of the present invention. As can be seen, as the frequency changes from 2.0 to 3.4GHz in Figure 7a, the amplitude of the I and Q signals change accordingly, (as shown in Figures 7c and 7b respectively). Without any feedback to tune the RC phase shifter, the amplitudes of the, I and Q signals remain different, as shown in Figure 7d, thereby reducing the effect of the image rejection circuitry.

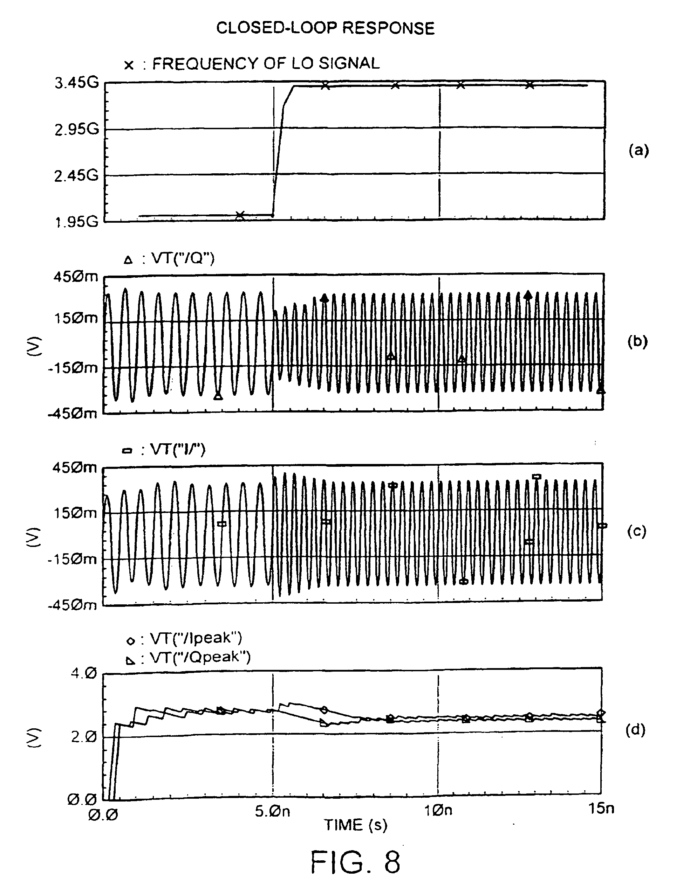

Figure 8 shows the response of the preferred embodiment shown in Figure 3, in which the tuning signal from the comparison of the peak detectors is fed back to the RC phase shifter. As the frequency changes from 2.0 to 3.4 GHz, (as shown in Figure 8a), the amplitudes of the I and Q signals initially become different. However, this change is detected by the amplitude detectors, and used to tune the RC phase shifter such that the amplitudes of the I and Q signals become equal once more, as shown in Figure 8d.

According to the embodiment described above, the absolute accuracy of the amplitude detectors per se are not important, provided that the two amplitude detectors (one for the I branch and one for the Q branch) are matched. Similarly, the performance of the embodiment described above is not significantly degraded if the detection efficiency of the peak detectors is frequency dependent, as long as the two devices are matched.

Although the invention described above has been concerned with eliminating differences between the amplitudes of the output I and Q signals, the invention could equally be applied in situations where it is desired to introduce an amplitude difference to compensate for amplitude errors found elsewhere in the system, for example, to compensate for amplitude errors in the mixer conversion gains and/or in the IF-gain stages.

For example, in some systems, the gain of the I-mixer and the Q-mixer or an I_IF-phase shifter and a Q_IF-phase shifter are different. For example, when an all-pass phase shifter is used, the I_IF-phase shifter has a 45° phase shift (R=6000, C=1pF, f=100 MHZ) and the Q_IF-phase shifter uses R=3840Ω, C=1pF, f=100 MHZ. This gives different loading of the previous or following stages which in turn give gain differences between the I or Q path. Such differences may be corrected by purposely making the gain of the first and second peak detectors slightly different.

Alternatively, the subtracting circuit (37 in Figure 3) may be given a slightly different gain for the two inputs, i.e. 1:1.1 or 1:0.9 instead of 1:1.

The image reject circuitry described above may be implemented as an integrated circuit, for example using CMOS, BiCMOS, SiGe, or GaAs technology.

Various modifications which are obvious to those skilled in the art may be made without departing from the scope of the invention as defined by the appended claims. For example, resistors 51 and 53 of Figure 4 may be replaced by inductors, or a combination of inductors and resistors.

## Claims

1. An image reject circuit comprising:
a local oscillator (26) for producing a local oscillator signal;
a tunable phase shifting network (29) for receiving the local oscillator signal (1,3) and producing an output in-phase (I) signal (13,25) and an output quadrature (Q) signal <15,27) **characterised by**;
a first amplitude detector (33) for determining the amplitude of the output in-phase (I) signal;
a second amplitude detector (35) for determining the amplitude of the output quadrature (Q) signal; and,
means (37) for determining the difference between the amplitudes of the output in-phase (I) and quadrature (Q) signals, to produce a tuning signal (39) for tuning the phase shifting network to bring the difference between the amplitudes of the output in-phase (I) and quadrature (Q) signals towards a desired level.

2. An image reject circuit as claimed in claim 1, wherein the phase shifting network has first and second input terminals for receiving the local oscillator signal, and comprises:
a first phase shifting circuit connected between the first input terminal and a voltage reference;
a second phase shifting circuit connected between the voltage reference and the second, input terminal;
first and second pairs of complementary output lines connected to each of the first and second phase shifting circuits; and,
a tuning input for receiving the tuning signal.

3. An image reject circuit as claimed in claim 2, wherein each of the first and second phase shifting circuits comprises a bridge circuit, each bridge circuit comprising:
first and second parallel arms connected between the respective input terminal and the voltage reference;
the first arm comprising a resistive element connected in series with a capacitive element;
the second arm comprising a capacitive element connected in series with a resistive element; and,
each I and Q output line being connected to a respective junction between the series connected resistive element and capacitive element.

4. An image reject circuit as claimed in any one of claims 1 to 3, wherein the phase shifting network is tuned by adjusting an RC time constant.

5. An image reject circuit as claimed in claim 4, wherein the capacitive element comprises a reverse polarity junction diode, which is tuned in accordance with the tuning signal.

6. An image reject circuit as claimed in claim 4, wherein the resistive element comprises a variable resistor, which is tuned in accordance with the tuning signal.

7. An image reject circuit as claimed in claim 4, wherein the resistive element comprises a variable resistor, the capacitive element comprises a reverse polarity junction diode, both of which are tuned in accordance with the tuning signal.

8. An image reject circuit as claimed in claim 6 or 7, wherein the resistive element comprises a MOSFET operated in its triode region.

9. An image reject circuit as claimed in claim 2, wherein each of the first and second phase shifting circuits comprises a bridge circuit, each bridge circuit comprising:
first and second parallel arms connected between the respective input terminal and the voltage reference;
the first arm comprising a resistive element connected in series with an inductive element;
the second arm comprising an inductive element connected in series with a resistive element;
each I and Q output line being connected to a respective junction between the series connected resistive element and inductive element;
wherein the phase shifting network is tuned by adjusting the RL time constant.

10. An image reject circuit as claimed in claim 2, wherein each of the first and second phase shifting circuits comprises a bridge circuit, each bridge circuit comprising:
first and second parallel arms connected between the respective input terminal and the voltage reference;
the first arm comprising an inductive element connected in series with a capacitive element;
the second arm comprising a capacitive element connected in series with an inductive element;
each I and Q output line being connected to a respective junction between the series connected inductive element and capacitive element;
wherein the phase shifting network is tuned by adjusting the LC time constant.

11. An image reject circuit as claimed in any one of claims 1 to 10, wherein the first and second amplitude detectors comprise:
an input terminal for receiving the input signal;
a resistor and forward polarity diode connected between the input terminal and an output terminal; and,
a capacitor connected between the output terminal and ground.

12. An image reject circuit as claimed in any one of claims 1 to 10, wherein the first and second amplitude detectors each comprise a two stage amplitude detector.

13. An image reject circuit as claimed in any one of claims 1 to 10, wherein the amplitude detectors include a quadratic function circuit.

14. An image reject circuit as claimed in any one of the preceding claims, wherein the desired difference between the amplitudes of the output I and Q signals is substantially zero.

15. An image reject circuit as claimed in claim 14, further comprising a limiting stage for removing any residual difference between the amplitudes of the I and Q signals.

16. An image reject circuit as claimed in claim 14 or 15, further comprising an RC poly-phase filter section for removing any residual difference between the amplitudes of the I and Q signals.

17. An image reject circuit as claimed in any one of claim 1 to 13, wherein the desired difference between the amplitudes of the output I and Q signals is set to a predetermined level, to compensate for an amplitude error found elsewhere in the system.

18. An image reject circuit as claimed in any one of the preceding claims, wherein the circuitry is implemented in bipolar technology.

19. An image reject circuit as claimed in any one of claims 1 to 17, wherein the circuitry is implemented in CMOS, BiCMOS, SiGe or GaAs technology.

20. An image reject circuit as claimed in any one of the preceding claims, wherein the circuit is implemented as an integrated circuit.

21. An image reject circuit as claimed in any preceding claim, further comprising a second tunable phase shifting network located in an intermediate frequency path, the tuning signal of the first phase shifting network also being used to tune the second phase shifting network.

22. A method of rejecting images in a receiver circuit comprising a local oscillator (26) for producing a local oscillator signal (1, 3), and a tunable phase shifting network (29) for receiving the local oscillator signal and producing an output in-phase (I) signal (13, 25) and an output quadrature (Q) signal (15,27), **characterised in that** the method comprises the steps of;
determining the amplitude of the output in-phase (I) signal;
determining the amplitude of the output quadrature (Q) signal;
determining the difference between the amplitudes of the output in-phase (I) and quadrature (Q) signals, to produce a tuning signal (39) ; and,
using the tuning signal (39) to tune the phase shifting network (29) to bring the difference between the amplitudes of the output in-phase (I) and quadrature (Q) signals towards a desired level.

23. A method as claimed in claim 22, wherein the phase shifting network is tuned by adjusting an RC time constant of the phase shifting network.

24. A method as claimed in claim 23, wherein the RC time constant is changed by changing the voltage across junction diodes, the change in voltage causing the capacitance of the junction diodes to change accordingly.

25. A method as claimed in claim 23, wherein the RC time constant is changed by changing the resistance value of a variable resistor

26. A method as claimed in claims 23, wherein the RC time constant is changed by changing the capacitance value and the resistance value.

27. A method as claimed in claim 25 or 26, wherein the resistance value is changed by operating a MOSFET in its triode region.

28. A method as claimed in claim 22, wherein the phase shifting network is tuned by adjusting an RL time constant of the phase shifting network.

29. A method as claimed in claim 22, wherein the phase shifting network is tuned by adjusting an LC time constant of the phase shifting network.

30. A method as claimed in any one of claims 22 to 29, wherein the amplitudes of the I and Q signals are determined using amplitude detectors.

31. A method as claimed in any one of claims 22 to 30, in which the receiver further comprises a second tunable phase shifting network located in an intermediate frequency path, the method comprising the further step of tuning the second phase shifting network according to the tuning signal determined for the first phase shifting network.

32. A method as claimed in any one of claims 22 to 31, wherein the phase shifting network is tuned such that the desired difference between the amplitudes of the I and Q signals is substantially zero.

33. A method as claimed in any one of claims 22 to 32, wherein the phase shifting network is tuned such that the desired difference between the amplitudes of the output I and Q signals is set to a predetermined level, to compensate for an amplitude error found elsewhere in the system.

## Revendications

1. Circuit de réjection d'image, comprenant :
un oscillateur local (26) destiné à produire un signal d'oscillateur local ;
un réseau de déphasage accordable (29), destiné à recevoir le signal d'oscillateur local (1, 3) et à produire un signal de sortie (I) en phase (13, 25) et un signal de sortie (Q) en quadrature (15, 27),
**caractérisé par** :
un premier détecteur d'amplitude (33), destiné à déterminer l'amplitude du signal de sortie en phase (I) ;
un second détecteur d'amplitude (35), destiné à déterminer l'amplitude du signal de sortie en quadrature (Q) ; et
un moyen (37) destiné à déterminer la différence entre les amplitudes des signaux de sortie en phase (I) et en quadrature (Q) afin de produire un signal d'accord (39) destiné à accorder le circuit de déphasage afin d'amener la différence entre les amplitudes des signaux de sortie en phase (I) et en quadrature (Q) à un niveau souhaité.

2. Circuit de réjection d'image selon la revendication 1, dans lequel le réseau de déphasage possède une première et une seconde borne d'entrée pour recevoir le signal d'oscillateur local et comprend :
un premier circuit de déphasage connecté entre la première borne d'entrée et une référence de tension ;
un second circuit de déphasage connecté entre la référence de tension et la seconde borne d'entrée ;
une première et une seconde paire de lignes de sortie complémentaires connectées à chacun des premier et second circuits de déphasage ; et
une entrée d'accord pour recevoir le signal d'accord.

3. Circuit de réjection d'image selon la revendication 2, dans lequel chacun des premier et second circuits de déphasage comprend un circuit de pont, chaque circuit de pont comprenant :
une première et une seconde branche parallèle connectées entre les bornes d'entrée respectives et la référence de tension ;
la première branche comprenant un élément résistant monté en série avec un élément capacitif ;
la seconde branche comprenant un élément capacitif monté en série avec un élément résistant ; et
chacune des lignes de sortie I et Q étant connectée à une des jonctions respectives entre l'élément résistant et l'élément capacitif montés en série.

4. Circuit de réjection d'image selon l'une quelconque des revendications 1 à 3, dans lequel le réseau de déphasage est accordé en ajustant une constante de temps RC.

5. Circuit de réjection d'image selon la revendication 4, dans lequel l'élément capacitif comprend une diode à jonction de polarité inverse qui est accordée en fonction du signal d'accord.

6. Circuit de réjection d'image selon la revendication 4, dans lequel l'élément résistant comprend une résistance variable qui est accordée en fonction du signal d'accord.

7. Circuit de réjection d'image selon la revendication 4, dans lequel l'élément résistant comprend une résistance variable, l'élément capacitif comprend une diode à jonction de polarité inverse, tous deux étant accordés en fonction du signal d'accord.

8. Circuit de réjection d'image selon la revendication 6 ou 7, dans lequel l'élément résistant comprend un MOSFET exploité dans sa région de triode.

9. Circuit de réjection d'image selon la revendication 2, dans lequel chacun des premier et second circuits de déphasage comprend un circuit de pont, chaque circuit de pont comprenant :
une première et une seconde branches parallèles connectées entre les bornes d'entrée respectives et la référence de tension ;
la première branche comprenant un élément résistant monté en série avec un élément inductif ;
la seconde branche comprenant un élément inductif monté en série avec un élément résistant ;
chacune des lignes de sortie I et Q étant connectée à une des jonctions respectives entre l'élément résistant et l'élément inductif montés en série ;
le réseau de déphasage étant accordé en ajustant la constante de temps RL.

10. Circuit de réjection d'image selon la revendication 2, dans lequel chacun des premier et second circuits de déphasage comprend un circuit de pont, chaque circuit de pont comprenant :
une première et une seconde branches parallèles connectées entre les bornes d'entrée respectives et la référence de tension ;
la première branche comprenant un élément inductif monté en série avec un élément capacitif ;
la seconde branche comprenant un élément capacitif monté en série avec un élément inductif ;
chacune des lignes de sortie I et Q étant connectée à une des jonctions respectives entre l'élément inductif et l'élément capacitif montés en série ;
le réseau de déphasage étant accordé en ajustant la constante de temps LC.

11. Circuit de réjection d'image selon l'une quelconque des revendications 1 à 10, dans lequel le premier et le second détecteur d'amplitude comprennent :
une borne d'entrée destinée à recevoir le signal d'entrée ;
une résistance et une diode à polarité directe connectées entre la borne d'entrée et une borne de sortie ; et
un condensateur connecté entre la borne de sortie et la masse.

12. Circuit de réjection d'image selon l'une quelconque des revendications 1 à 10, dans lequel le premier et le second détecteur d'amplitude comprennent chacun un détecteur d'amplitude à deux étages ;

13. Circuit de réjection d'image selon l'une quelconque des revendications 1 à 10, dans lequel les détecteurs d'amplitude incluent un circuit à fonction quadratique.

14. Circuit de réjection d'image selon l'une quelconque des revendications précédentes, dans lequel la différence souhaitée entre les amplitudes des signaux de sortie I et Q est substantiellement nulle.

15. Circuit de réjection d'image selon la revendication 14, comprenant en outre un étage limiteur destiné à éliminer toute différence résiduelle entre les amplitudes des signaux I et Q.

16. Circuit de réjection d'image selon la revendication 14 ou 15, comprenant en outre une section de filtrage RC à phases multiples destinée à éliminer toute différence résiduelle entre les amplitudes des signaux I et Q.

17. Circuit de réjection d'image selon l'une quelconque des revendications 1 à 13, dans lequel la différence souhaitée entre les amplitudes des signaux de sortie I et Q est réglée à un niveau prédéterminé afin de compenser une erreur d'amplitude rencontrée par ailleurs dans le système.

18. Circuit de réjection d'image selon l'une quelconque des revendications précédentes, dans lequel les circuits sont réalisés en technologie bipolaire.

19. Circuit de réjection d'image selon l'une quelconque des revendications 1 à 17, dans lequel les circuits sont réalisés en technologie CMOS, BiCMOS, SiGe ou GaAs.

20. Circuit de réjection d'image selon l'une quelconque des revendications précédentes, dans lequel le circuit est réalisé sous la forme d'un circuit intégré.

21. Circuit de réjection d'image selon l'une quelconque des revendications précédentes, comprenant en outre un second réseau de déphasage accordable situé sur un chemin de fréquence intermédiaire, le signal d'accord du premier réseau de déphasage étant également utilisé pour accorder le second réseau de déphasage.

22. Procédé de réjection d'images dans un circuit récepteur comprenant un oscillateur local (26), destiné à produire un signal d'oscillateur local (1, 3), et un réseau de déphasage accordable (29), destiné à recevoir le signal d'oscillateur local et à produire un signal de sortie (I), en phase (13, 25) et un signal de sortie (Q), en quadrature (15, 27), **caractérisé en ce que** le procédé comprend les étapes consistant à :
déterminer l'amplitude du signal de sortie en phase (I) ;
déterminer l'amplitude du signal de sortie en quadrature (Q) ;
déterminer la différence entre les amplitudes des signaux de sortie en phase (I) et en quadrature (Q) afin de produire un signal d'accord (39) ; et
utiliser le signal d'accord (39) afin d'accorder le circuit de déphasage (29) pour amener la différence entre les amplitudes des signaux de sortie en phase (I) et en quadrature (Q) à un niveau souhaité.

23. Procédé selon la revendication 22, dans lequel le réseau de déphasage est accordé en ajustant une constante de temps RC du réseau de déphasage.

24. Procédé selon la revendication 23, dans lequel la constante de temps RC est modifiée en faisant varier la tension aux bornes de diodes à jonction, le changement de tension faisant varier en conséquence la capacité des diodes à jonction.

25. Procédé selon la revendication 23, dans lequel la constante de temps RC est modifiée en faisant varier la valeur de résistance d'une résistance variable.

26. Procédé selon la revendication 23, dans lequel la constante de temps RC est modifiée en faisant varier la valeur de capacité et la valeur de résistance.

27. Procédé selon la revendication 25 ou 26, dans lequel la valeur de résistance est modifiée en faisant fonctionner un MOSFET dans sa région de triode.

28. Procédé selon la revendication 22, dans lequel le réseau de déphasage est accordé en ajustant une constante de temps RL du réseau de déphasage.

29. Procédé selon la revendication 22, dans lequel le réseau de déphasage est accordé en ajustant une constante de temps LC du réseau de déphasage.

30. Procédé selon l'une quelconque des revendications 22 à 29, dans lequel les amplitudes des signaux I et Q sont déterminées à l'aide de détecteurs d'amplitude.

31. Procédé selon l'une quelconque des revendications 22 à 30, dans lequel le récepteur comprend en outre un second réseau de déphasage accordable situé sur un chemin de fréquence intermédiaire, le procédé comprend en outre l'étape consistant à accorder le second réseau de déphasage en utilisant le signal d'accord déterminé pour le premier réseau de déphasage.

32. Procédé selon l'une quelconque des revendications 22 à 31, dans lequel la différence souhaitée entre les amplitudes des signaux de sortie I et Q est substantiellement nulle.

33. Procédé selon l'une quelconque des revendications 22 à 32, dans lequel le réseau de déphasage est accordé de manière à ce que la différence souhaitée entre les amplitudes des signaux de sortie I et Q soit réglée à un niveau prédéterminé, dans le bus de compenser une erreur d'amplitude rencontrée par ailleurs dans le système.

## Patentansprüche

1. Spiegelfrequenz-Unterdrückungsschaltung, die folgendes aufweist:
einen lokalen Oszillator (26) zum Erzeugen eines lokalen Schwingungssignals;
ein abstimmbares Phasenkompensationsnetz (29) zum Empfangen des lokalen Schwingungssignals (1, 3) und zum Erzeugen eines Inphase(I)-Ausgangssignals (13, 25) und eines Quadratur(Q)-Ausgangssignals (15, 27), **gekennzeichnet durch**
einen ersten Amplituden-Detektor (33) zum Bestimmen der Amplitude des Inphase(I)-Ausgangssignals;
einen zweiten Amplituden-Detektor (35) zum Bestimmen der Amplitude des Quadratur(Q)-Ausgangssignals; und
eine Einrichtung (37) zum Bestimmen der Differenz zwischen den Amplituden des Inphase(I)-Ausgangssignals und des Quadratur(Q)-Ausgangssignals, um ein Abstimmsignal (39) zum Abstimmen des Phasenkompensationsnetzes zu erzeugen, um die Differenz zwischen den Amplituden des Inphase(I)-Ausgangssignals und des Quadratur(Q)-Ausgangssignals in Richtung eines erwünschten Pegels zu bringen.

2. Spiegelfrequenz-Unterdrückungsschaltung nach Anspruch 1, wobei das Phasenkompensationsnetz ein erstes und ein zweites Eingangs-Terminal zum Empfang des lokalen Schwingungssignals aufweist, und wobei die Schaltung folgendes aufweist:
eine erste Phasenschieberschaltung, die zwischen dem ersten Eingangs-Terminal und einer Spannungsreferenz angeschlossen ist;
eine zweite Phasenschieberschaltung, die zwischen der Spannungsreferenz und dem zweiten Eingangs-Terminal angeschlossen ist;
erste und zweite Paare von komplementären Ausgangsleitungen, die mit jeder der ersten und zweiten Phasenschieberschaltungen verbunden sind; und
einen Abstimmungseingang zum Empfangen des Abstimmsignals .

3. Spiegelfrequenz-Unterdrückungsschaltung nach Anspruch 2, wobei jede der ersten und zweiten Phasenschieberschaltungen eine Brückenschaltung aufweist, und wobei jede Brückenschaltung folgendes aufweist:
erste und zweite Parallel-Arme, die zwischen den entsprechenden Eingangs-Terminals und der Spannungsreferenz angeschlossen sind;
wobei der erste Arm ein Widerstandselement aufweist, das in Reihe mit einem kapazitiven Element geschaltet ist;
wobei der zweite Arm ein kapazitives Element aufweist, das in Reihe mit einem Widerstandselement geschaltet ist; und
wobei sowohl die I- als auch die Q-Ausgangsleitung zwischen dem in Reihe geschalteten Widerstandselement und kapazitiven Element an einem entsprechenden Verbindungspunkt angeschlossen sind.

4. Spiegelfrequenz-Unterdrückungsschaltung nach einem der vorhergehenden Ansprüche, wobei das Phasenkompensationsnetz durch Einstellen einer RC-Zeitkonstante abgestimmt wird.

5. Spiegelfrequenz-Unterdrückungsschaltung nach Anspruch 4, wobei das kapazitive Element eine Flächendiode mit umgekehrter Polarität aufweist, die in Übereinstimmung mit dem Abstimmsignal abgestimmt wird.

6. Spiegelfrequenz-Unterdrückungsschaltung nach Anspruch 4, wobei das Widerstandselement einen variablen Widerstand aufweist, der in Übereinstimmung mit dem Abstimmsignal abgestimmt wird.

7. Spiegelfrequenz-Unterdrückungsschaltung nach Anspruch 4, wobei das Widerstandselement einen variablen Widerstand aufweist, das kapazitive Element eine Flächendiode mit umgekehrter Polarität aufweist, und
wobei beide in Übereinstimmung mit dem Abstimmsignal abgestimmt werden.

8. Spiegelfrequenz-Unterdrückungsschaltung nach Anspruch 6 oder 7, wobei das Widerstandselement einen in seinem Trioden-Bereich betriebenen MOSFET aufweist.

9. Spiegelfrequenz-Unterdrückungsschaltung nach Anspruch 2, wobei jede der ersten und zweiten Phasenschieberschaltungen eine Brückenschaltung aufweist, und wobei jede Brückenschaltung folgendes aufweist:
erste und zweite Parallel-Arme, die zwischen den entsprechenden Eingangs-Terminals und der Spannungsreferenz angeschlossen sind;
wobei der erste Arm ein Widerstandselement aufweist, das in Reihe mit einem induktiven Element geschaltet ist;
der zweite Arm ein induktives Element aufweist, das in Reihe mit einem Widerstandselement geschaltet ist;
wobei sowohl die I- als auch die Q-Ausgangsleitung zwischen dem in Reihe geschalteten Widerstandselement und induktiven Element an einem entsprechenden Verbindungspunkt angeschlossen sind;
wobei das Phasenkompensationsnetz durch Einstellen der RL-Zeitkonstante abgestimmt wird.

10. Spiegelfrequenz-Unterdrückungsschaltung nach Anspruch 2, wobei sowohl die erste als auch die zweite Phasenschieberschaltung einen Brückenschaltung aufweist, und wobei jede Brückenschaltung folgendes aufweist:
erste und zweite Parallel-Arme, die zwischen den entsprechenden Eingangs-Terminals und der Spannungsreferenz angeschlossen sind;
wobei der erste Arm ein induktives Element aufweist, das in Reihe mit einem kapazitiven Element geschaltet ist;
wobei der zweite Arm ein kapazitives Element aufweist, das in Reihe mit einem induktiven Element geschaltet ist;
wobei sowohl die I- als auch die Q-Ausgangsleitung zwischen dem in Reihe geschalteten induktiven Element und kapazitiven Element an einem entsprechenden Verbindungspunkt angeschlossen sind;
wobei das Phasenkompensationsnetz abgestimmt wird, indem die LC-Zeitkonstante eingestellt wird.

11. Spiegelfrequenz-Unterdrückungsschaltung nach einem der Ansprüche 1 bis 10, wobei die ersten und zweiten Amplituden-Detektoren folgendes aufweisen:
ein Eingangs-Terminal zum Empfangen des EingangsSignals;
einen Widerstand sowie eine Diode mit Vorwärts-Polarität, wobei die Diode zwischen dem Eingangs-Terminal und einem Ausgangs-Terminal angeschlossen ist; und
eine Kapazität, die zwischen dem Ausgangs-Terminal und der Erde angeschlossen ist.

12. Spiegelfrequenz-Unterdrückungsschaltung nach einem der Ansprüche 1 bis 10, wobei die ersten und zweiten Amplituden-Detektoren jeweils einen zweistufigen Amplituden-Detektor aufweisen.

13. Spiegelfrequenz-Unterdrückungsschaltung nach einem der Ansprüche 1 bis 10, wobei die Amplituden-Detektoren eine Quadratfunktions-Schaltung aufweisen.

14. Spiegelfrequenz-Unterdrückungsschaltung nach einem der vorhergehenden Ansprüche, wobei die erwünschte Differenz zwischen den Amplituden des I-Ausgangssignals und des Q- Ausgangssignals im wesentlichen Null beträgt.

15. Spiegelfrequenz-Unterdrückungsschaltung nach Anspruch 14, die ferner eine Beschränkungsstufe bzw. Grenzwertstufe zum Entfernen jedweder Rest-Differenz zwischen den Amplituden der I- und Q-Signale aufweist.

16. Spiegelfrequenz-Unterdrückungsschaltung nach Anspruch 14 oder 15, die ferner einen RC-Polyphasen-Filterabschnitt zum Entfernen jedweder Rest-Differenz zwischen den Amplituden der I- und Q-Signale aufweist.

17. Spiegelfrequenz-Unterdrückungsschaltung nach einem der Ansprüche 1 bis 13, wobei die erwünschte Differenz zwischen den Amplituden der I- und Q- Ausgangssignale auf einem vorab festgelegten Pegel gesetzt ist, um einen anderweitig in dem System aufgefundenen Amplitudenfehler zu kompensieren.

18. Spiegelfrequenz-Unterdrückungsschaltung nach einem der vorhergehenden Ansprüche, wobei die Verschaltung in einer Bipolar-Technologie implementiert ist.

19. Spiegelfrequenz-Unterdrückungsschaltung nach einem der Ansprüche 1 bis 17, wobei die Verschaltung in CMOS-, BiCMOS-, SiGe- oder GaAs-Technologie implementiert ist.

20. Spiegelfrequenz-Unterdrückungsschaltung nach einem der vorhergehenden Ansprüche, wobei die Schaltung als eine integrierte Schaltung implementiert ist.

21. Spiegelfrequenz-Unterdrückungsschaltung nach einem der vorhergehenden Ansprüche, die ferner ein zweites abstimmbares Phasenkompensationsnetz aufweist, das in einem Zwischenfrequenz-Leitungspfad angeordnet ist,
wobei das Abstimmsignal der ersten Phasenkompensationsnetzes ebenso dazu verwendet wird, um das zweite Phasenkompensationsnetz abzustimmen.

22. Verfahren zur Spiegelfrequenzunterdrückung in einer Empfängerschaltung, die einen lokalen Oszillator (26) zum Erzeugen eines lokalen Schwingungssignals (1, 3) und ein abstimmbares Phasenkompensationsnetz (29) zum Empfangen des lokalen Schwingungssignals u d zum Erzeugen eines Inphase(I)-Ausgangssignals (13, 25) und eines Quadratur(Q)-Ausgangssignals (15, 27) aufweist, **dadurch gekennzeichnet, dass** das Verfahren die folgenden Verfahrensschritte aufweist:
Bestimmen der Amplitude des Inphase(I)-Ausgangssignals;
Bestimmen der Amplitude des Quadratur(Q)-Ausgangssignals;
Bestimmen der Differenz zwischen den Amplituden des Inphase(I)-Ausgangssignals und des Quadratur(Q)-Ausgangssignals, um ein Abstimmsignal (39) zu erzeugen; und
Verwenden des Abstimmsignals (39) zum Abstimmen des Phasenkompensationsnetzes (29), um die Differenz zwischen den Amplituden des Inphase(I)-Ausgangssignals und des Quadratur(Q)-Ausgangssignals in Richtung eines erwünschten Pegels zu bringen.

23. Verfahren nach Anspruch 22, wobei das Phasenkompensationsnetz durch Einstellen einer RC-Zeitkonstante des Phasenkompensationsnetzes abgestimmt wird.

24. Verfahren nach Anspruch 23, wobei die RC-Zeitkonstante geändert wird, indem die Spannung über Flächendioden geändert wird, wobei die Änderung hinsichtlich der Spannung bewirkt, dass sich die Kapazität der Flächendioden entsprechend ändert.

25. Verfahren nach Anspruch 22, wobei die RC-Zeitkonstante geändert wird, indem der Widerstandswert eines variablen Widerstandes geändert wird.

26. Verfahren nach Anspruch 23, wobei die RC-Zeitkonstante geändert wird, indem der Wert der Kapazität und der Widerstandswert geändert werden.

27. Verfahren nach Anspruch 25 oder 26, wobei der Widerstandswert geändert wird, indem ein MOSFET in seinem Trioden-Bereich betrieben wird.

28. Verfahren nach Anspruch 22, wobei das Phasenkompensationsnetz abgestimmt wird, indem eine RL-Zeitkonstante des Phasenkompensationsnetzes eingestellt wird.

29. Verfahren nach Anspruch 22, wobei das Phasenkompensationsnetz abgestimmt wird, indem eine LC-Zeitkonstante des Phasenkompensationsnetzes eingestellt wird.

30. Verfahren nach einem der Ansprüche 22 bis 29, wobei die Amplituden der I-und Q-Signale unter Verwendung von Amplituden-Detektoren bestimmt werden.

31. Verfahren nach einem der Ansprüche 22 bis 30, in welchem der Empfänger ferner ein zweites abstimmbares Phasenkompensationsnetz aufweist, welches in einem Zwischenfrequenz-Leitungspfad angeordnet ist, wobei das Verfahren den weiteren Verfahrensschritt des Abstimmens des zweiten Phasenkompensationsnetzes gemäß dem für das erste Phasenkompensationsnetz bestimmten Abstimmsignal aufweist.

32. Verfahren nach einem der Ansprüche 22 bis 31, wobei das Phasenkompensationsnetz derart abgestimmt wird, dass die erwünschte Differenz zwischen den Amplituden der I- und Q-Signale im wesentlichen Null beträgt.

33. Verfahren nach einem der Ansprüche 22 bis 32, wobei das Phasenkompensationsnetz derart abgestimmt wird, dass die erwünschte Differenz zwischen den Amplituden der I- und Q- Ausgangssignale auf einem vorab festgelegten Pegel gesetzt ist, um einen anderweitig in dem System aufgefundenen Amplitudenfehler zu kompensieren.
